# EUROPEAN PATENT APPLICATION

(11) **EP 4 675 504 A1**
(43) Date of publication of application: **07.01.2026**
(21) Application number: 24781358.7
(22) Date of filing: 21.03.2024
(51) Int. Cl.: G06N 3/065, H10B 99/00, G06N 3/063, H10N 70/20, H10N 70/00

(54) **UPDATE CELLS, NEUROMORPHIC CIRCUIT COMPRISING SAME, AND NEUROMORPHIC CIRCUIT OPERATION METHOD**

(30) Priority: 31.03.2023 KR 20230043112; 08.02.2024 KR 20240019783
(71) Applicant: Seoul National University R&DB Foundation, Seoul 08826 (KR)
(72) Inventor: KIM, Sangbum, Seoul 06006 (KR); KANG, Jaehyeon, Seoul 08786 (KR)
(74) Representative: Isarpatent
(86) International application number: PCT/KR2024/095600
(87) International publication number: WO 2024/205370

(57) **Abstract**

An update cell, a neuromorphic circuit including the same, and a method of operating a neuromorphic circuit are disclosed. The disclosed neuromorphic circuit may include an update cell array, wherein the update cell array may include a plurality of word lines, a plurality of bit lines which intersect the plurality of word lines, and a plurality of update cells respectively disposed at intersections of the plurality of word lines and the plurality of bit lines. The update cell may include a capacitor including a first electrode and a second electrode, a switching transistor including a first node connected to the second electrode, a second node connected to the bit line, and a gate connected to the word line, and a charging/discharging circuit unit connected to the capacitor for charging and discharging the capacitor. A comparison circuit connected to each of the plurality of bit lines may be further provided, and the comparison circuit may be configured to distinguish and output a first signal, a second signal, and a third signal based on a positive (+) threshold voltage and a negative (-) threshold voltage.

## Description

### TECHNICAL FIELD

The present invention relates to electronic circuits/devices, methods of operating the same, and apparatuses including electronic circuits/devices, and more particularly, to an update cell, a neuromorphic circuit including the same, and a method of operating a neuromorphic circuit.

### BACKGROUND ART

As the scaling down of transistors reaches its limit, the neuromorphic computing system is receiving a lot of attention as a new concept that may overcome the limitations of the existing von Neumann type computer system. Neuromorphic computing is a technology which implements artificial intelligence behaviors by imitating the human brain in terms of a hardware. Focusing on the fact that the human brain performs very complex functions but consumes only about 20W of energy, neuromorphic computing imitates the human brain structure itself, so that artificial intelligence operations such as terribly superior association, reasoning, and recognition capabilities may be performed with ultra-low power as compared to existing von Neumann computing.

The neuromorphic system which operates such neuromorphic computing is composed of numerous neurons (neuron devices) and synapses (synapse devices), just like the human brain, and includes additional circuits for signal processing and transmission. Synapses remember the connection strength (weight) according to the correlation of spikes expressed by neurons, and in some cases, adjust the connection strength through the process of potentiation and depression. At this time, the connection strength may be expressed as the electrical conductance of the synapse. As synaptic devices, the devices based on RRAM (resistive random access memory) or memristors have been widely studied, and recently, synaptic devices based on MOSFET (metal-oxide-semiconductor field-effect transistor) are also being studied.

However, it is difficult to perform on-chip training by using only existing low bit devices, and analog devices have a problem that write noise is tremendously severe. Therefore, it is necessary to perform weight update by using capacitor-based devices with relatively low write noise. In the case of charge-based synaptic devices, the weight may be varied with current and time, which is very advantageous in securing linearity and symmetry and it has an advantage of relatively low write noise.

Additionally, in the case of many existing learning methods which use two arrays in one layer, information learned in one array must be transferred to the other array by using an analog-to-digital converter (ADC). In the case of ADC, it may cause enormous energy consumption and area overhead in neuromorphic computing. In neuromorphic computing, the area overhead occupied by the ADC may be about 2/3 or more, and the proportion of power overhead occupied by the ADC may be about 3/4 or more. Therefore, it is necessary to secure area and energy advantages by not using the ADC or by greatly simplifying the ADC configuration.

### DISCLOSURE OF THE INVENTION

### TECHNICAL PROBLEM

The technological object to be achieved by the present invention is to provide an update cell which is energy efficient, has low noise impact, and may reduce area overhead, and a neuromorphic circuit including the same.

Furthermore, the technological object to be achieved by the present invention is to provide a neuromorphic circuit which may perform a weight update by using a capacitor-based device with low write noise, and may also obtain area and energy advantages by using a small-sized comparison circuit rather than a conventional ADC.

Furthermore, the technological object to be achieved by the present invention is to provide operation methods of the update cell and the neuromorphic circuit, and a learning method applying the same.

Furthermore, the technological object to be achieved by the present invention is to provide a method of operating a neuromorphic circuit which may remarkably reduce power consumption, have less noise influence, and reduce area overhead, and a learning method applying the same.

The objects to be achieved by the present invention is not limited to the objects mentioned above, and other objects not mentioned will be understood by those skilled in the art from the description below.

According to one embodiment of the present invention, there is provided a neuromorphic circuit comprising: an update cell array, and wherein the update cell array includes a plurality of word lines; a plurality of bit lines intersecting the plurality of word lines; and a plurality of update cells respectively disposed at intersections of the plurality of word lines and the plurality of bit lines, and wherein the update cell includes a capacitor including a first electrode and a second electrode; a switching transistor including a first node connected to the second electrode, a second node connected to the bit line, and a gate connected to the word line; and a charging/discharging circuit unit connected to the capacitor for charging and discharging the capacitor.

A comparison circuit unit connected to each of the plurality of bit lines may be further provided, and the comparison circuit unit may be configured to distinguish and output a first signal, a second signal, and a third signal based on a positive (+) threshold voltage and a negative (-) threshold voltage.

In connection with the charging/discharging circuit unit, a first power source for applying a positive (+) power supply voltage, a second power source for applying a negative (-) power supply voltage, and a connection node connected to the second electrode may be defined.

The charging/discharging circuit unit may include a first programming transistor and a first selection transistor connected in series between the first power source and the connection node, and a second programming transistor and a second selection transistor connected in series between the second power source and the connection node.

The charging/discharging circuit unit includes a first programming transistor connected between the first power source and the connection node; a second programming transistor connected between the second power source and the connection node; a first AND gate circuit or a first NAND gate circuit connected to a gate of the first programming transistor; and a second AND gate circuit or a second NAND gate circuit connected to a gate of the second programming transistor.

The charging/discharging circuit unit may include a first programming transistor connected between the first power source and the connection node; and a second programming transistor connected between the second power source and the connection node, and wherein each of the first and second programming transistors may have a dual gate structure or a double gate structure.

The positive (+) power supply voltage and the negative (-) power supply voltage may be supplied by one power supply unit, the power supply unit may include functions of the first and second power sources, and the charging/discharging circuit unit may include a programming transistor and a selection transistor connected in series between the power supply unit and the connection node.

The positive (+) power supply voltage and the negative (-) power supply voltage may be supplied by one power supply unit, the power supply unit may include functions of the first and second power sources, and the charging and discharging circuit unit may include a programming transistor connected between the power supply unit and the connection node, and an AND gate circuit or a NAND gate circuit connected to a gate of the programming transistor.

The neuromorphic circuit may further include an inference cell array, and the inference cell array includes a plurality of first wirings; a plurality of second wirings intersecting the plurality of first wirings; and a plurality of inference cells respectively disposed at intersections of the plurality of first wirings and the plurality of second wirings.

According to another embodiment of the present invention, there is provided a neuromorphic circuit comprising: an update cell array including a plurality of word lines, a plurality of bit lines intersecting the plurality of word lines, and a plurality of update cells respectively disposed at intersections of the plurality of word lines and the plurality of bit lines, and wherein the update cell includes a capacitor including a first electrode and a second electrode, and a switching transistor including a first node connected to the second electrode, a second node connected to the bit line, and a gate connected to the word line; an update multiplexer connected to each of the plurality of bit lines; and a first switch connected between each of the plurality of bit lines and the update multiplexer corresponding thereto.

The neuromorphic circuit may further include a comparison circuit unit which is connected to each of the plurality of bit lines and may distinguish and output a first signal, a second signal, and a third signal based on a positive (+) threshold voltage and a negative (-) threshold voltage; and a second switch connected between each of the plurality of bit lines and the comparison circuit unit corresponding thereto.

The update multiplexer may be connected to a first power supply for applying a positive (+) power supply voltage for a potentiation operation; a second power supply for applying a negative (-) power supply voltage for a depression operation; and may be connected to a ground power source for applying a ground voltage for non-implementation of update.

According to another embodiment of the present invention, there is provided a method of operating neuromorphic circuit comprising an update cell array including a plurality of word lines, a plurality of bit lines intersecting the plurality of word lines, and a plurality of update cells respectively disposed at intersections of the plurality of word lines and the plurality of bit lines, and a comparison circuit unit connected to each of the plurality of bit lines and capable of distinguishing and outputting a first signal, a second signal, and a third signal based on a positive (+) threshold voltage and a negative (-) threshold voltage, and the method of operating a neuromorphic circuit includes performing a read operation for the update cell array, and wherein the performing a read operation includes a step for distinguishing and outputting the first signal, the second signal, and the third signal by applying an input signal to a word line selected from among the plurality of word lines, and using the comparison circuit unit for a first group of update cells connected to the selected word line.

The neuromorphic circuit may further include a plurality of first wirings, a plurality of second wirings which intersect the plurality of first wirings, and an inference cell array having a plurality of inference cells respectively disposed at intersections of the plurality of first wirings and the plurality of second wirings, and the method of operating a neuromorphic circuit may further include performing an update operation for the inference cell array, and the performing an update operation may include applying an input signal to a first wiring selected from the plurality of first wirings, and performing an update operation for a first group of inference cells connected to the selected first wiring, wherein the update operation for the first group of inference cells is performed according to the first signal, the second signal, and the third signal at a position corresponding to each of the update cells of the first group.

An 1 step potentiation operation may be performed for the inference cell corresponding to the first signal, an 1 step depression operation may be performed for the inference cell corresponding to the second signal, and an update operation may not be performed for the inference cell corresponding to the third signal.

The performing a read operation for the update cell array may be repeatedly performed while selecting the word lines one by one, and the performing an update operation for the inference cell array may be repeatedly performed while selecting the first wirings one by one.

### ADVANTAGEOUS EFFECTS

According to embodiments of the present invention, it is possible to implement an update cell which is energy efficient, has less noise impact, and may reduce area overhead, and a neuromorphic circuit including the same.

According to embodiments of the present invention, it is possible to implement a neuromorphic circuit which may perform a weight update by using a capacitor-based device with low write noise, and may also obtain area and energy advantages by using a small-sized comparison circuit rather than a conventional ADC.

Furthermore, according to embodiments of the present invention, it is possible to implement a method of operating a neuromorphic circuit which may remarkably reduce power consumption, have less noise influence, and reduce area overhead, and a learning method applying the same. The method of operating a neuromorphic circuit according to embodiments may be usefully applied to on-chip learning.

According to embodiments of the present invention, it is possible to implement a neuromorphic device (neuromorphic system) having excellent performance and remarkable advantages in terms of area and energy.

However, the effects of the present invention are not limited to the above effects and may be expanded in various ways without departing from the technological spirit and scope of the present invention.

### BRIEF DESCRIPTION OF THE DRAWINGS

FIG. 1 is a circuit diagram illustrating an update cell and a neuromorphic circuit including the same according to an embodiment of the present invention.
FIG. 2 to FIG. 5 are circuit diagrams illustrating a charging/discharging circuit unit which may be applied to an update cell according to an embodiment of the present invention.
FIG. 6A to FIG. 6C are circuit diagrams illustrating a charging/discharging circuit unit which may be applied to an update cell according to an embodiment of the present invention.
FIG. 7 is a circuit diagram illustrating a charging/discharging circuit unit which may be applied to an update cell according to an embodiment of the present invention.
FIG. 8 and FIG. 9 are circuit diagrams illustrating a charging/discharging circuit unit which may be applied to an update cell according to an embodiment of the present invention.
FIG. 10 is a circuit diagram illustrating a charging/discharging circuit unit which may be applied to an update cell according to an embodiment of the present invention.
FIG. 11A to FIG. 11C are circuit diagrams illustrating a charging/discharging circuit which may be applied to an update cell according to an embodiment of the present invention.
FIG. 12 is a graph for explaining the characteristics of a comparison circuit unit which may be applied to a neuromorphic circuit according to an embodiment of the present invention.
FIG. 13 is a circuit diagram illustrating an inference cell array which may be applied to a neuromorphic circuit according to an embodiment of the present invention.
FIG. 14 is a circuit diagram for explaining a method of operating a neuromorphic circuit according to an embodiment of the present invention.
FIG. 15 is a circuit diagram for explaining a method of operating a neuromorphic circuit according to an embodiment of the present invention.
FIG. 16 is a circuit diagram for explaining a method of operating a neuromorphic circuit according to an embodiment of the present invention.
FIG. 17 is a circuit diagram for explaining a method of operating a neuromorphic circuit according to an embodiment of the present invention.
FIG. 18 is a graph showing the evaluation result that a high degree of learning is obtained even with a low bit inference cell when applying the update cell and learning method proposed in an embodiment of the present invention.
FIG. 19 is a circuit diagram illustrating the configuration of a circuit applied to the neuromorphic circuit used to obtain the results of FIG. 18.
FIG. 20 is a circuit diagram illustrating an update cell and a neuromorphic circuit including the same according to another embodiment of the present invention.
FIG. 21 is a circuit diagram for explaining a method of operating a neuromorphic circuit according to another embodiment of the present invention.
FIG. 22 is a circuit diagram for explaining a method of operating a neuromorphic circuit according to another embodiment of the present invention.

### BEST MODE FOR CARRYING OUT THE INVENTION

Hereinafter, the embodiments of the present invention will be described in detail with reference to the accompanying drawings.

The embodiments of the present invention to be described below are provided to more clearly explain the present invention to those skilled in the art, and the scope of the present invention is not limited by the following embodiments, and the embodiments may be modified in many different forms.

The terms used in this specification are used to describe specific embodiments and are not intended to limit the present invention. The terms indicating a singular form used herein may include plural forms unless the context clearly indicates otherwise. Also, as used herein, the terms, "comprise" and/or "comprising" specify the presence of the stated shape, step, number, operation, member, element, and/or group thereof and does not exclude the presence or addition of one or more other shapes, steps, numbers, operations, elements, elements and/or groups thereof. Furthermore, the term, "connection" used in this specification means not only a direct connection of certain members, but also a concept including an indirect connection in which other members are interposed between the members.

Furthermore, in the present specification, when a member is said to be located "on" another member, this arrangement includes not only a case in which a member is in contact with another member, but also a case where another member exists between the two members. As used herein, the term, "and/or" includes any one and all combinations of one or more of the listed items. Furthermore, the terms of degree such as "about" and "substantially" used in the present specification are used as a range of values or degrees, or as a meaning close thereto, taking into account inherent manufacturing and material tolerances, and exact or absolute numbers provided to aid in the understanding of this application are used to prevent the infringers from unfairly exploiting the stated disclosure.

Hereinafter, embodiments of the present invention will be described in detail with reference to the accompanying drawings. A size or a thickness of areas or parts shown in the accompanying drawings may be slightly exaggerated for clarity of the specification and convenience of description. The same reference numbers indicate the same configuring elements throughout the detailed description.

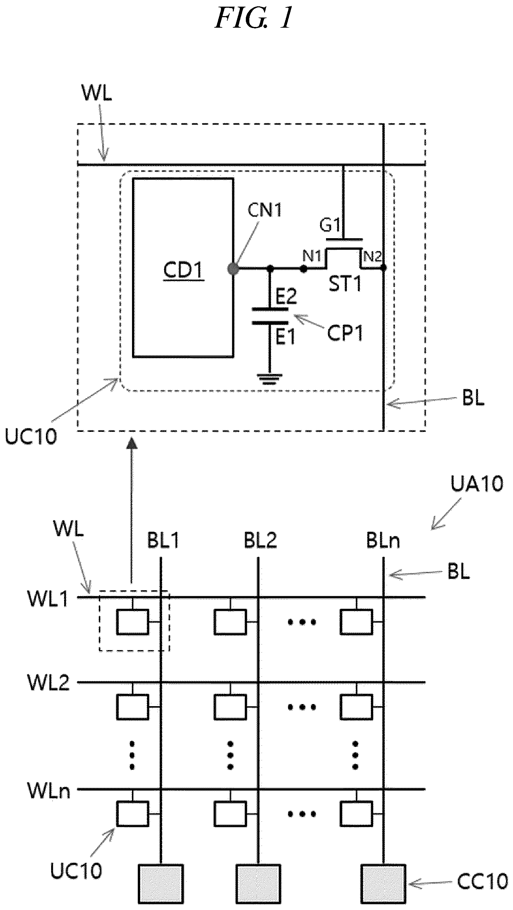

FIG. 1 is a circuit diagram showing an update cell UC10 and a neuromorphic circuit including the same according to an embodiment of the present invention.

Referring to FIG. 1, a neuromorphic circuit according to an embodiment of the present invention may include an update cell array UA10. The update cell array UA10 may be referred to as an 'update cell array circuit' or an 'update cell array device.' The update cell array UA10 may be a device used to update (i.e., weight update) an inference cell array.

The update cell array UA10 may include a plurality of word lines WL, a plurality of bit lines BL intersecting (crossing) the plurality of word lines WL, and a plurality of update cells UC10 respectively disposed at intersections of the plurality of word lines WL and the plurality of bit lines BL. The plurality of word lines WL may include the word lines indicated as WL1, WL2, ... , WLn. The plurality of bit lines BL may include the bit lines indicated as BL1, BL2, ... , BLn. The number of the plurality of word lines WL and the number of the plurality of bit lines BL may be the same or different.

The update cell UC10 may include a capacitor CP1, a switching transistor ST1 connected to the capacitor CP1, and a charging/discharging circuit unit CD1 connected to the capacitor CP1 to charge and discharge the capacitor CP1. The capacitor CP1 may include a first electrode E1 and a second electrode E2. Additionally, the capacitor CP1 may include a dielectric layer (i.e., a capacitor dielectric layer) disposed between the first electrode E1 and the second electrode E2. The switching transistor ST1 may include a first node N1 connected to the second electrode E2, a second node N2 connected to the bit line BL, and a gate G1 connected to the word line WL. The first node N1 and the second node N2 may be a drain and a source, respectively, or vice versa. The gate G1 may be controlled by the word line WL. The first electrode E1 of the capacitor CP1 may be grounded, but is not limited thereto.

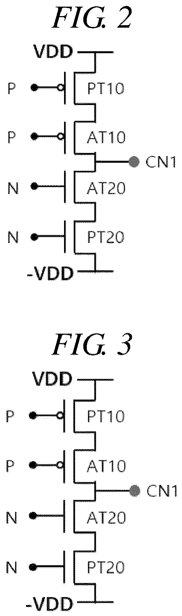

The charging/discharging circuit unit CD1 may be a circuit unit for charging and discharging the capacitor CP1. Since the weight may be determined according to the amount of charge stored in the capacitor CP1, the charging/discharging circuit unit CD1 may be used to update the weight of the update cell UC10. Therefore, the charging/discharging circuit unit CD1 may be called an 'update circuit unit'. With respect to the charging/discharging circuit unit CD1, a first power source for applying a positive (+) power supply voltage, a second power source for applying a negative (-) power supply voltage, and a connection node CN1 connected to the second electrode E2 of the capacitor CP1 may be defined. The specific configuration which the charging/discharging circuit unit CD1 may have will be described in detail below with reference to FIG. 2 to FIG. 11C.

The update cell UC10 according to an embodiment of the present invention may be a capacitor-based device with low write noise. Additionally, the update cell UC10 may be said to be a charge-based synapse device. A charge-based synapse device is advantageous in securing linearity and symmetry and may have an advantage of low write noise. According to an embodiment of the present invention, a weight update may be performed by using a capacitor-based device with low write noise.

According to one embodiment, the neuromorphic circuit may further include a comparison circuit unit CC10 connected to each of the plurality of bit lines BL. The comparison circuit unit CC10 may be configured to distinguish and output a first signal, a second signal, and a third signal based on a positive (+) threshold voltage and a negative (-) threshold voltage.

The comparison circuit unit CC10 may determine an output signal by comparing the magnitude of the measured voltage with a positive (+) threshold voltage and a negative (-) threshold voltage, and may output any one of the first signal, the second signal and the third signal according to the comparison result. The comparison circuit unit CC10 may output the first signal if the measured voltage is greater than the positive (+) threshold voltage, and the comparison circuit unit CC10 may output the second signal if the measured voltage is less than the negative (-) threshold voltage. If the magnitude of the measured voltage is between the positive (+) threshold voltage and the negative (-) threshold voltage, the comparison circuit unit CC10 may output the third signal. Accordingly, the first signal may be an upper signal, the second signal may be a lower signal, and the third signal may be an intermediate signal. For example, the first signal may be a signal corresponding to +1, the second signal may be a signal corresponding to -1, and the third signal may be a signal corresponding to 0. According to one embodiment, the comparison circuit unit CC10 may be a circuit which distinguishes and outputs only the first signal, the second signal, and the third signal based on the positive (+) threshold voltage and the negative (-) threshold voltage.

The comparison circuit unit CC10 may be a circuit capable of distinguishing and outputting an upper signal, an intermediate signal, and a lower signal by distinguishing between a positive (+) threshold voltage and a negative (-) threshold voltage. In other words, the comparison circuit unit CC10 may be a circuit that may distinguish and output +1, 0, and -1 signals by distinguishing between positive (+) and negative (-) threshold voltages. The comparison circuit unit CC10 may include, for example, a sense amplifier (S/A), a 2-bit analog-to-digital converter (ADC), a ternary content-addressable memory (TCAM), and the like. The comparison circuit unit CC10 may be or include a sense amplifier (S/A), may be or include a 2-bit ADC, or may be or include a TCAM. However, the specific type of circuit which may distinguish between positive (+) threshold voltage and negative (-) threshold voltage is not limited to the above descriptions and may vary in various ways. The configuration of the comparison circuit unit CC10 may be much simpler, occupy a smaller area, and be energy efficient compared to a conventional ADC (general ADC). The comparison circuit unit CC10 may have remarkable advantages in terms of area and energy.

FIG. 2 to FIG. 5 are circuit diagrams illustrating a charging/discharging circuit unit which may be applied to an update cell according to an embodiment of the present invention.

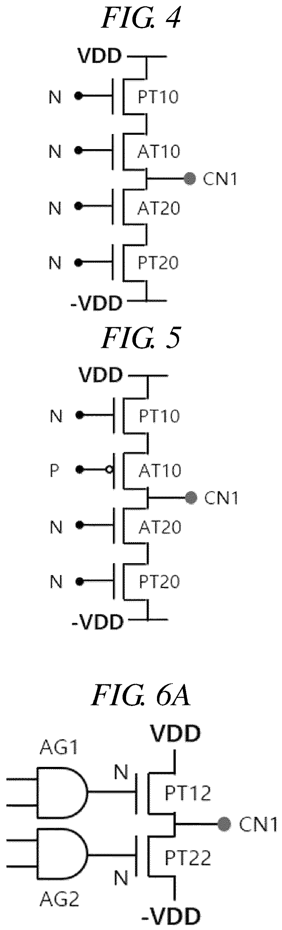

Referring to FIG. 2 to FIG. 5, in connection with the charging/discharging circuit unit applied to the update cell according to an embodiment of the present invention, a first power source for applying a positive (+) power supply voltage, a second power source for applying a negative (-) power supply voltage, and a connection node CN1 connected to the second electrode (E2 in FIG. 1) of the capacitor (CP1 in FIG. 1) may be defined. The positive (+) power supply voltage may be VDD, and the negative (-) power supply voltage may be -VDD. The absolute values of VDD and - VDD may be the same, but may also be different. The notations of VDD, -VDD, and CN1 are the same in FIGS. 6A to 11C.

The charging/discharging circuit unit may include a first programming transistor PT10 and a first selection transistor AT10 connected in series between the first power source (i.e., a power source applying VDD) and the connection node CN1. Furthermore, the charging/discharging circuit unit may include a second programming transistor PT20 and a second selection transistor AT20 connected in series between the second power source (i.e., a power source applying -VDD) and the connection node CN1. The first programming transistor PT10 and the second programming transistor PT20 may be used for weight update. The first selection transistor AT10 and the second selection transistor AT20 may be used for cell selection. The positions of the first programming transistor PT10 and the first selection transistor AT10 may be changed, and similarly, the positions of the second programming transistor PT20 and the second selection transistor AT20 may be changed.

In the case of FIG. 2, the first programming transistor PT10 and the first selection transistor AT10 may be a P-type transistor, and the second programming transistor PT20 and the second selection transistor AT20 may be an N-type transistor.

In the case of FIG. 3, the first programming transistor PT10 may be a P-type transistor, and the first selection transistor AT10, the second programming transistor PT20, and the second selection transistor AT20 may be an N-type transistor.

In the case of FIG. 4, the first programming transistor PT10, the first selection transistor AT10, the second programming transistor PT20, and the second selection transistor AT20 may be N-type transistors.

In the case of FIG. 5, the first selection transistor AT10 may be a P-type transistor, and the first programming transistor PT10, the second programming transistor PT20, and the second selection transistor AT20 may be N-type transistor.

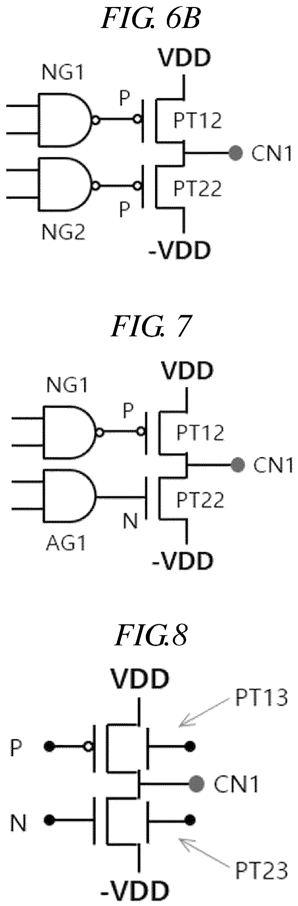

FIG. 6A and FIG. 6B are circuit diagrams illustrating a charging/discharging circuit unit which may be applied to an update cell according to an embodiment of the present invention.

Referring to FIG. 6A, the charging/discharging circuit unit may include a first programming transistor PT12 connected between the first power source (i.e., a power source applying VDD) and the connection node CN1, a second programming transistor PT22 connected between a second power source (i.e., a power source applying -VDD) and the connection node CN1, a first AND gate circuit AG1 connected to the gate of the first programming transistor PT12, and a second AND gate circuit AG2 connected to the gate of the second programming transistor PT22. The output terminal of the first AND gate circuit AG1 may be connected to the first programming transistor PT12, and the output terminal of the second AND gate circuit AG2 may be connected to the second programming transistor PT22. The first and second programming transistors PT12 and PT22 may be used for updating. The first and second AND gate circuits AG1 and AG2 may be used for cell selection. The positions of the first programming transistor PT12 and the second programming transistor PT22 may be changed. The first and second programming transistors PT12 and PT22 may be N-type transistors.

Referring to FIG. 6B, the charging/discharging circuit unit may include a first programming transistor PT12 connected between the first power source (i.e., a power source applying VDD) and the connection node CN1, a second programming transistor PT22 connected between a second power source (i.e., a power source applying -VDD) and the connection node CN1, a first NAND gate circuit NG1 connected to the gate of the first programming transistor PT12, and second NAND gate circuit NG2 connected to the gate of the second programming transistor PT22. The output terminal of the first NAND gate circuit NG1 may be connected to the first programming transistor PT12, and the output terminal of the second NAND gate circuit NG2 may be connected to the second programming transistor PT22. The first and second programming transistors PT12 and PT22 may be used for updating. The first and second NAND gate circuits NG1 and NG2 may be used for cell selection. The positions of the first programming transistor PT12 and the second programming transistor PT22 may be changed. The first and second programming transistors PT12 and PT22 may be P-type transistors.

FIG. 7 is a circuit diagram illustrating a charging/discharging circuit which may be applied to an update cell according to an embodiment of the present invention.

Referring to FIG. 7, the charging/discharging circuit unit may include a first programming transistor PT12 connected between the first power source (i.e., a power source applying VDD), a second programming transistor PT22 connected between and a second power source (i.e., a power source applying -VDD) and the connection node CN1, a NAND gate circuit NG1 connected to the gate of the first programming transistor PT12, and a AND gate circuit AG1 connected to the gate of the second programming transistor PT22. The first programming transistor PT12 may be a P-type transistor, and the second programming transistor PT22 may be an N-type transistor. The output terminal of the NAND gate circuit NG1 may be connected to the first programming transistor PT12, and the output terminal of the AND gate circuit AG1 may be connected to the second programming transistor PT22. The first and second programming transistors PT12 and PT22 may be used for updating. The NAND gate circuit NG1 and the AND gate circuit AG1 may be used for cell selection. The positions of the first programming transistor PT12 and the second programming transistor PT22 may be changed.

Furthermore, in FIG. 7, when the first programming transistor PT12 is an N-type transistor and the second programming transistor PT22 is a P-type transistor, the output terminal of the AND gate circuit AG1 may be connected to the gate of the first programming transistor PT12, and the output terminal of the NAND gate circuit NG1 may be connected to the gate of the second programming transistor PT22.

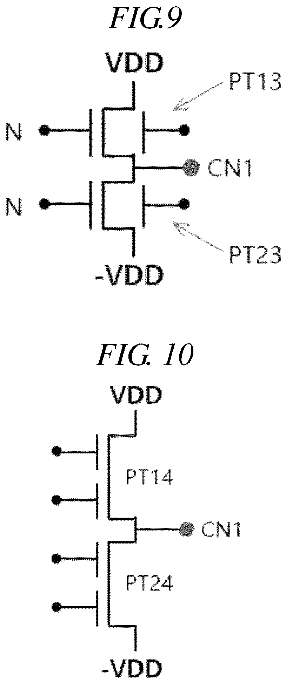

FIG. 8 and FIG. 9 are circuit diagrams illustrating a charging/discharging circuit unit which may be applied to an update cell according to an embodiment of the present invention.

Referring to FIG. 8 and FIG. 9, the charging/discharging circuit unit may include a first programming transistor PT13 connected between the first power source (i.e., a power supply applying VDD) and the connection node CN1, and a second programming transistor PT23 connected between the second power source (i.e., a power supply applying -VDD) and the connection node CN1. Each of the first and second programming transistors PT13 and PT23 may have a dual gate structure. That is, each of the first and second programming transistors PT13 and PT23 may include a top gate and a bottom gate. The two gates of the first programming transistor PT13 and the two gates of the second programming transistor PT23 may be used for cell selection. The positions of the first programming transistor PT13 and the second programming transistor PT23 may be changed to each other. In the embodiment of FIG. 8, the first programming transistor PT13 may be a P-type transistor, and the second programming transistor PT23 may be an N-type transistor. In the embodiment of FIG. 9, the first and second programming transistors PT13 and PT23 may be N-type transistors.

FIG. 10 is a circuit diagram illustrating a charging/discharging circuit which may be applied to an update cell according to an embodiment of the present invention.

Referring to FIG. 10, the charging/discharging circuit unit may include a first programming transistor PT14 connected between the first power source (i.e., a power source applying VDD) and the connection node CN1, and a second programming transistor PT24 connected between the second power source (i.e., a power source applying -VDD) and the connection node CN1. Each of the first and second programming transistors PT14 and PT24 may have a double gate structure. That is, each of the first and second programming transistors PT14 and PT24 may include two gates which are spaced apart in a lateral direction. The two gates of the first programming transistor PT14 and the two gates of the second programming transistor PT24 may be used for cell selection. The positions of the first programming transistor PT14 and the second programming transistor PT24 may be changed to each other.

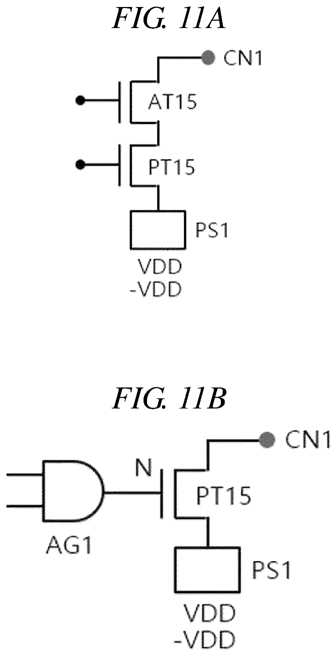

FIG. 11A is a circuit diagram illustrating a charging/discharging circuit which may be applied to an update cell according to an embodiment of the present invention.

Referring to FIG. 11A, a positive (+) power supply voltage (i.e., VDD) and a negative (-) power supply voltage (i.e., -VDD) may be supplied by one power supply unit PS1. In this case, both of the function of the first power supply to apply the positive (+) power supply voltage (i.e., VDD) and the function of the second power supply to apply the negative (-) power supply voltage (i.e., -VDD) may be included in the power supply unit PS1. The power supply unit PS1 may have a multiplexer configuration and may have a voltage switching function. In this embodiment, the charging/discharging circuit unit may include a programming transistor PT15 and a selection transistor AT15 connected in series between the power supply unit PS1 and the connection node CN1. The programming transistor PT15 may be used for updating, and the selection transistor AT15 may be used for cell selection. The positions of the programming transistor PT15 and the selection transistor AT15 may be exchanged. Each of the programming transistor PT15 and the selection transistor AT15 may be an N-type transistor or a P-type transistor.

FIG. 11B is a circuit diagram illustrating a charging/discharging circuit which may be applied to an update cell according to an embodiment of the present invention.

Referring to FIG. 11B, the charging/discharging circuit unit may include a programming transistor PT15 connected between the power supply unit PS1 and the connection node CN1. Additionally, the charging/discharging circuit unit may include an AND gate circuit AG1 connected to the gate of the programming transistor PT15. The output terminal of the AND gate circuit AG1 may be connected to the gate of the programming transistor PT15. The programming transistor PT15 may be an N-type transistor. The programming transistor PT15 may be used for updating. The AND gate circuit AG1 may be used for cell selection.

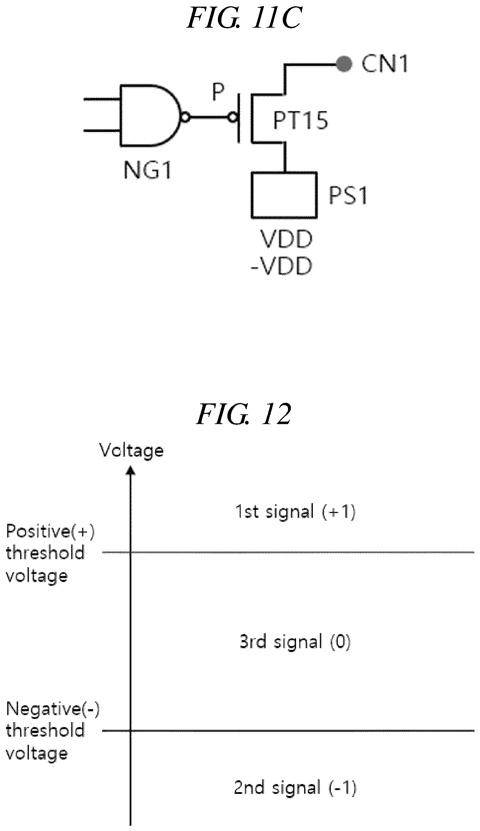

FIG. 11C is a circuit diagram illustrating a charging/discharging circuit which may be applied to an update cell according to an embodiment of the present invention.

Referring to FIG. 11C, the charging/discharging circuit unit may include a programming transistor PT15 connected between the power supply unit PS1 and the connection node CN1. Additionally, the charging/discharging circuit unit may include a NAND gate circuit NG1 connected to the gate of the programming transistor PT15. The output terminal of the NAND gate circuit NG1 may be connected to the gate of the programming transistor PT15. The programming transistor PT15 may be a P-type transistor. The programming transistor PT15 may be used for updating. The NAND gate circuit NG1 may be used for cell selection.

However, the specific configuration of the charging/discharging circuit unit described with reference to FIG. 2 to FIG. 11C is illustrative and may be varied as needed.

According to one embodiment, for the charging and discharging circuit unit, the first power supply for applying a positive (+) power supply voltage (e.g., VDD) and the second power source for applying a negative (-) power supply voltage (e.g., -VDD) may be used. The second power source may be a power supply which applies a negative (-) power supply voltage (e.g., -VDD) rather than a ground power source.

In this way, when using VDD and -VDD, the voltage of the capacitor CP1 (i.e., Vcap) may change toward 0V whenever a read operation is performed, and in this regard, an advantage may be obtained in the learning process. The capacitor CP1 may be charged with the charges ranging from VDD to -VDD. Whenever a read operation is performed, charge sharing may occur between the capacitor CP1 and the bit line BL, and accordingly, the voltage (i.e., Vcap) of the capacitor CP1 may converge to a value approaching 0V. A circuit according to an embodiment of the present invention may be a device whose weight may be expressed from a negative number to a positive number. In the artificial intelligence learning process, it may be desirable to regularize the weights in a direction close to 0. In the circuit according to the embodiment of the present invention, since the voltage of the capacitor CP1 may converge to a value close to 0V due to charge sharing whenever a read operation is performed, an effect may be obtained that the weight is regularized in a direction close to 0.

FIG. 12 is a graph for explaining the characteristics of a comparison circuit unit which may be applied to a neuromorphic circuit according to an embodiment of the present invention.

Referring to FIG. 12, the neuromorphic circuit according to an embodiment of the present invention may further include a comparison circuit unit (CC10 in FIG. 1) connected to the bit line. The comparison circuit unit may be configured to distinguish and output a first signal, a second signal, and a third signal based on a positive (+) threshold voltage and a negative (-) threshold voltage. The comparison circuit unit may determine an output signal by comparing the magnitude of the measured voltage with a positive (+) threshold voltage and a negative (-) threshold voltage, and may output any one of the first signal, the second signal, and the first signal according to the comparison result. The comparison circuit unit may output the first signal when the measured voltage is greater than the positive (+) threshold voltage, and output the second signal when the measured voltage is less than the negative (-) threshold voltage. The comparison circuit unit may output the third signal if the magnitude of the measured voltage is between the positive (+) threshold voltage and the negative (-) threshold voltage. The first signal may be an upper signal, the second signal may be a lower signal, and the third signal may be an intermediate signal. For example, the first signal may be a signal corresponding to +1, the second signal may be a signal corresponding to -1, and the third signal may be a signal corresponding to 0. The comparison circuit unit may include, for example, a sense amplifier (S/A), a 2-bit analog-to-digital converter (ADC), a ternary content-addressable memory (TCAM), and the like, but the above members are not limited to those ones.

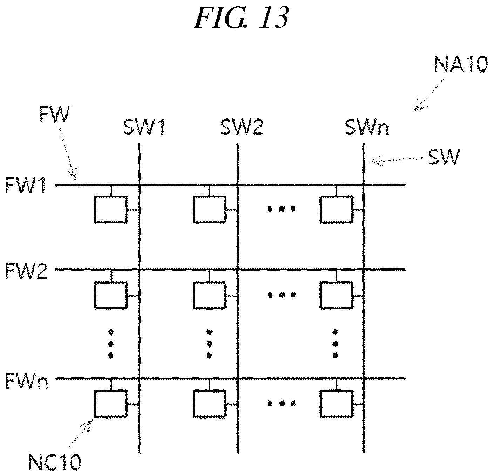

FIG. 13 is a circuit diagram illustrating an inference cell array NA10 which may be applied to a neuromorphic circuit according to an embodiment of the present invention.

Referring to FIG. 13, a neuromorphic circuit according to an embodiment of the present invention may include an inference cell array NA10. The inference cell array NA10 may be referred to as an 'inference cell array circuit' or an 'inference cell array device.' The inference cell array NA10 may be a device which performs an actual inference function in the neuromorphic circuit.

The inference cell array NA10 includes a plurality of first wirings FW, a plurality of second wirings SW intersecting (crossing) the plurality of first wirings FW, and a plurality of inference cells NC10 respectively disposed at intersections of the plurality of first wirings FW and the plurality of second wirings SW. The plurality of first wirings FW may include the first wirings indicated by FW1, FW2, ... , FWn. The plurality of second wirings SW may include the second wirings SW indicated by SW1, SW2, ... , SWn. The number of first wirings FW and the number of the plurality of second wirings SW may be the same or different. The inference cell NC10 may be referred to as a 'synapse cell' or a 'synapse device. In this respect, the inference cell array NA10 may be referred to as a 'synapse cell array'. The configuration of the inference cell NC10 is not particularly limited, and any existing synapse cell may be applied to the inference cell NC10.

One layer of the neuromorphic circuit may include the update cell array (UA10 in FIG. 1) and the inference cell array (NA10 in FIG. 13). The update cell array UA10 and the inference cell array NA10 may be electrically connected to each other. The plurality of bit lines BL of the update cell array UA10 and the plurality of second wirings SW of the inference cell array NA10 may be connected through a peripheral circuit. Additionally, the plurality of word lines WL of the update cell array UA10 and the plurality of first wirings FW of the inference cell array NA10 may be connected through a peripheral circuit. The update cell array UA10 and the inference cell array NA10 may have the same array size. In other words, the number of update cells UC10 and the number of inference cells NC10 may be the same. The neuromorphic circuit may include a plurality of update cell arrays UA10 and a plurality of inference cell arrays NA10.

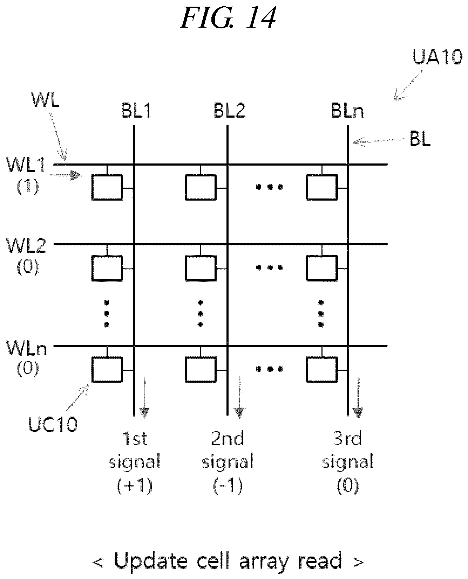

FIG. 14 is a circuit diagram for explaining a method of operating a neuromorphic circuit according to an embodiment of the present invention. This embodiment shows a method of operating the update cell array UA10 as described in FIG. 1.

Referring to FIG. 14, a method of operating a neuromorphic circuit according to an embodiment of the present invention may include a step for performing a read operation for the update cell array UA10. The step for performing the read operation may include a step for applying an input signal to a word line selected from the plurality of word lines WL, and for distinguishing and outputting the first signal, the second signal, and the third signal using by using the comparison circuit unit (CC10 in FIG. 1) for a first group of the update cells UC10 connected to the selected word line.

An input signal (activation voltage signal) corresponding to 1 may be applied to one selected word line (e.g., WL1), and a signal corresponding to 0 may be input to the remaining word lines. In an input case, a signal corresponding to 1 may be applied only to the word line to be selected (e.g., WL1), and a signal corresponding to 0 may be applied to the remaining word lines. That is, a 1-bit input signal may be used.

In the output case, it is possible to distinguish and output a first signal, a second signal, and a third signal for the update cells UC10 of the first group by using the comparison circuit unit (CC10 in FIG. 1) which may distinguish and output the first signal, second signal, and third signal based on the positive (+) threshold voltage and negative (-) threshold voltage. The first signal, the second signal, and the third signal may be referred to as read output signals. For example, the first signal may be a signal corresponding to +1, the second signal may be a signal corresponding to -1, and the third signal may be a signal corresponding to 0.

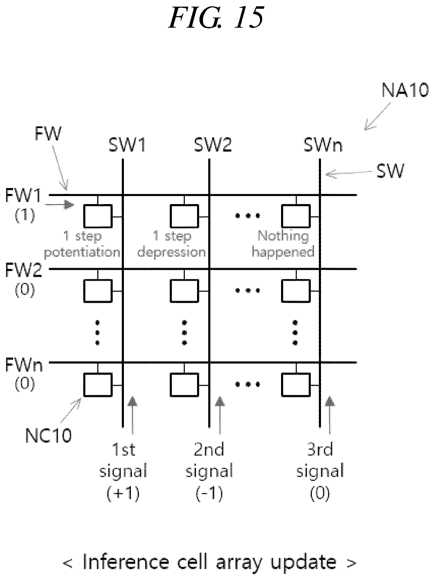

FIG. 15 is a circuit diagram for explaining a method of operating a neuromorphic circuit according to an embodiment of the present invention. This embodiment shows a method of operating the inference cell array NA10 as described in FIG. 13.

Referring to FIG. 15, the method of operating the neuromorphic circuit may include a step for performing an update operation for the inference cell array NA10. The step for performing the update operation may be performed in conjunction with the step for performing the read operation for the update cell array UA10 described in FIG. 14. The step for performing the update operation may include a step for applying an input signal to a first wiring selected from the plurality of first wirings FW, and for performing an update operation for a first group of the inference cells NC10 connected to the selected first wirings, wherein the update operation for the inference cells NC10 of the first group may be performed according to the first signal, the second signal, and the third signal at a position corresponding to each of the update cells UC10 of the first group.

For example, by selecting the first wiring (e.g., FW1) corresponding to the same position as the word line (e.g., WL1) selected from the update cell array UA10 in FIG. 14, an update operation may be performed for the inference cells NC10 of the first group connected to the selected first wiring (e.g., FW1). An input signal (activation voltage signal) corresponding to 1 may be applied to one selected first wirings (e.g., FW1), and a signal corresponding to 0 may be input to the remaining first wiring. Additionally, the signals corresponding to the read output signals output from the circuit of FIG. 14 may be input to the plurality of second wirings SW. That is, the first signal, the second signal, and the third signal may be input to the plurality of second wirings SW. The position of the signal output from each of the bit lines BL in FIG. 14 and the position of the signal input to each of the second wirings SW in FIG. 15 may be the same.

According to one embodiment, an 1 step potentiation operation may be performed for the inference cell NC10 corresponding to the first signal, an 1 step depression operation may be performed on the inference cell NC10 corresponding to the second signal, and an update operation may not be performed on the inference cell NC10 corresponding to the third signal. In other words, an 1 step weight update in the positive (+) direction may be performed for the inference cell NC10 corresponding to the first signal, an 1 step weight update in the negative (-) direction may be performed for the inference cell NC10 corresponding to the second signal, and no operation (no update operation) may be performed for the inference cell NC10 corresponding to the third signal.

The step for performing a read operation for the update cell array UA10 described in FIG. 14 may be repeatedly performed while selecting the word lines WL one by one, and the update operation for the inference cell array NA10 described in FIG. 15 may be repeatedly performed while selecting the first wirings FW one by one. The read operation of FIG. 14 and the update operation of FIG. 15 may be performed repeatedly. After performing a read operation for all of the word lines WL and an update operation for all of the first wirings FW, this process may be repeated again.

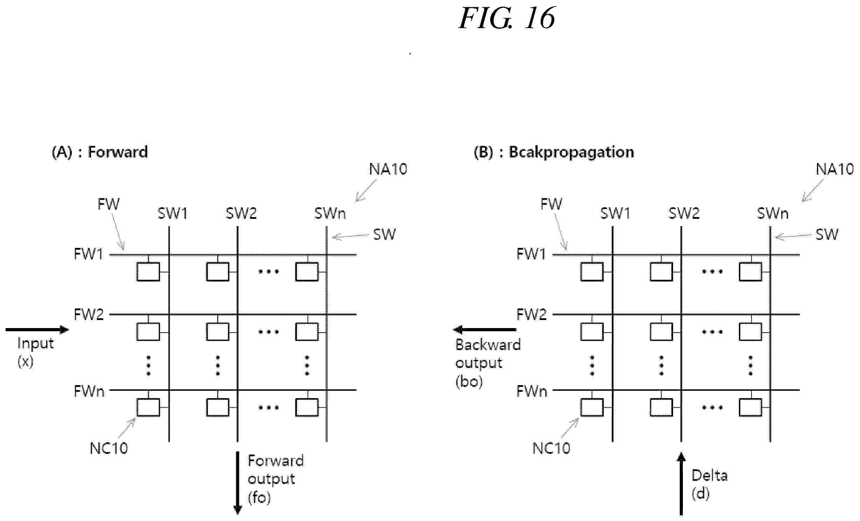

FIG. 16 is a circuit diagram for explaining a method of operating a neuromorphic circuit according to an embodiment of the present invention. FIG. 16 shows the process for performing read and backpropagation for the inference cell array NA10. FIG. 16 shows a forward read (inference) operation in (A), and shows a backpropagation operation in (B).

Referring to FIG. 16, a read and a backpropagation may be performed for the inference cell array NA10. Similar to the general method, an inference and a backpropagation may be performed. In addition, the update cell array may be updated based on the concerned information.

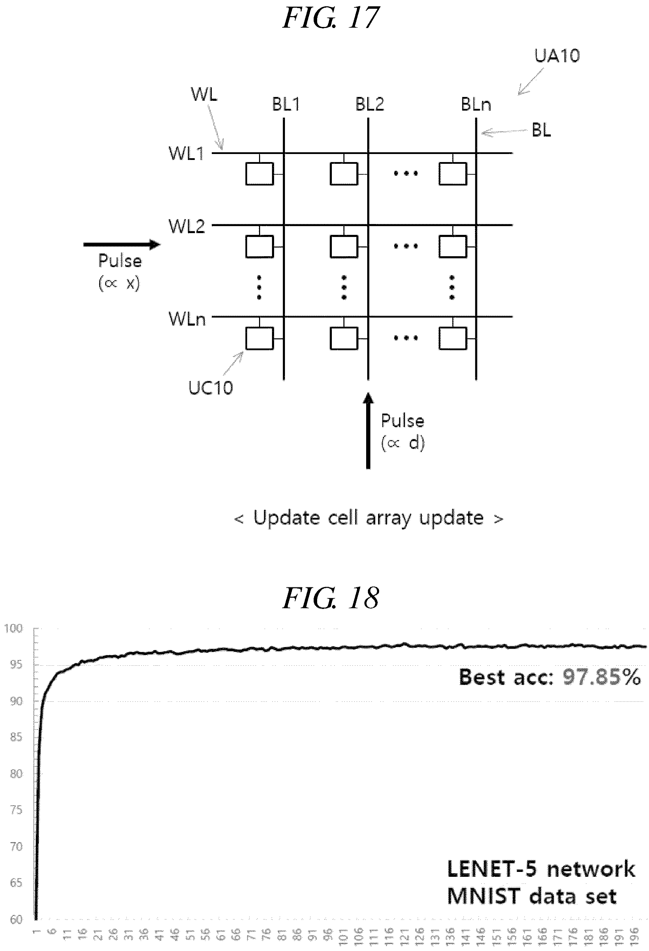

FIG. 17 is a circuit diagram for explaining a method of operating a neuromorphic circuit according to an embodiment of the present invention. FIG. 17 shows an update operation for the update cell array UA10.

Referring to FIG. 17, the update process of the update cell array UA10 may be confirmed. A pulse may be generated in proportion to the x and d values obtained based on inference and backpropagation performed in the inference cell array (NA10 in FIG. 16). Additionally, a fully-parallel update may be performed by using a pulse overlap method. The update may be performed in a manner similar to a general RPU (resistive processing unit) update.

After updating the update cell array UA10 as shown in FIG. 17, operations as described in FIGS. 14 and 15 may be performed.

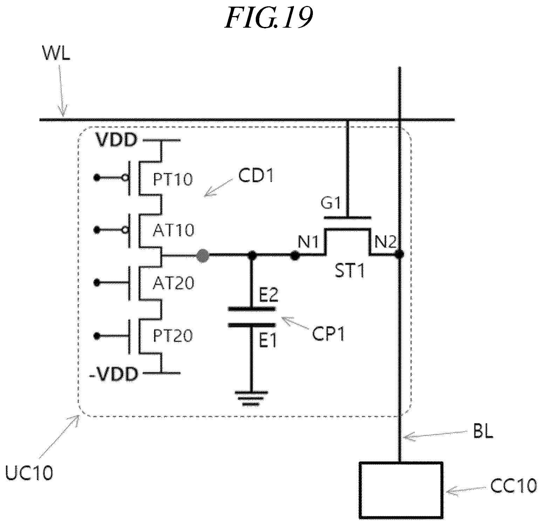

FIG. 18 is a graph showing the evaluation result that a high degree of learning is obtained even with a low bit inference cell when applying the update cell and learning method proposed in an embodiment of the present invention. FIG. 19 is a circuit diagram illustrating the configuration of a circuit applied to the neuromorphic circuit used to obtain the results of FIG. 18.

Referring to FIG. 18, the inference cell was 4 bits, and the update cell used at this time was a non-linear capacitive device. The inference accuracy was found to be very high, around 97.85%. Here, the charge share ratio was 20% and the retention ratio was 5e5 (i.e., 5×10⁵). The charge share ratio refers to the ratio of charge shared from the capacitor to the S.A. (sense amplifier) line parasitic capacitor each time a read is made. The S.A. is a device used as a comparison circuit unit. The retention ratio means retention divided by the update period.

FIG. 19 is a circuit diagram showing the configuration of a circuit applied to the neuromorphic circuit used to obtain the results of FIG. 18.

Referring to FIG. 19, the circuit configuration as described in FIG. 1 was applied, and at this time, the circuit of FIG. 2 was applied as the charging/discharging circuit unit CD1. Furthermore, a S.A. (sense amplifier) was used as the comparison circuit unit CC10. However, the circuit configuration of FIG. 19 is an example and may be changed in various ways.

According to an embodiment of the present invention, a learning method for on-chip training and the configuration of a circuit applicable thereto may be implemented. In on-chip learning, mini-batch based update may be easily implemented by applying two device arrays to one layer. Various related advantages and effects may be obtained by performing on-chip training.

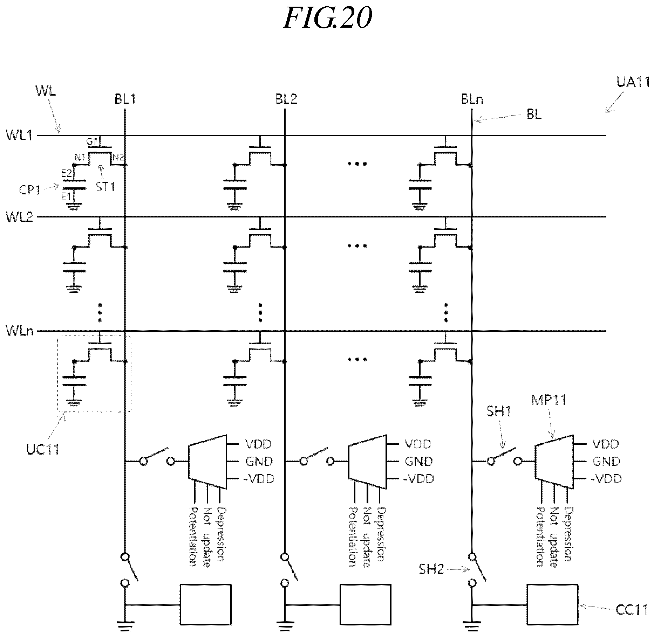

FIG. 20 is a circuit diagram illustrating an update cell UC11 and a neuromorphic circuit including the same according to another embodiment of the present invention.

Referring to FIG. 20, the neuromorphic circuit according to this embodiment may include an update cell array UA11. The update cell array UA11 may include a plurality of word lines WL, a plurality of bit lines BL intersecting (crossing) the plurality of word lines WL, and a plurality of update cells UC11 respectively disposed at intersections of the plurality of word lines WL and the plurality of bit lines BL. The plurality of word lines WL may include the word lines indicated as WL1, WL2, ... , WLn. The plurality of bit lines BL may include the bit lines indicated as BL1, BL2, ... , BLn. The number of word lines WL and the number of the bit lines BL may be the same or different.

The update cell UC11 may include a capacitor CP1 and a switching transistor ST1 connected to the capacitor CP1. The capacitor CP1 may include a first electrode E1 and a second electrode E2. The capacitor CP1 may include a dielectric layer (i.e., a capacitor dielectric layer) disposed between the first electrode E1 and the second electrode E2. The switching transistor ST1 may include a first node N1 connected to the second electrode E2, a second node N2 connected to the bit line BL, and a gate G1 connected to the word line WL. The first node N1 and the second node N2 may be a drain and a source, respectively, or vice versa. The gate G1 may be controlled by the word line WL. The first electrode E1 of the capacitor CP1 may be grounded, but is not limited thereto.

The neuromorphic circuit may include an update multiplexer MP11 connected to each of the plurality of bit lines BL. Additionally, the neuromorphic circuit may include a first switch SH1 connected between each of the plurality of bit lines BL and the corresponding update multiplexer MP11. The first switch SH1 may be a switching device (circuit). The first switch SH1 may be called an 'update switch'.

According to one embodiment, the update multiplexer MP11 may be connected to a first power supply to apply a positive (+) power supply voltage for a potentiation operation, a second power supply to apply a negative (-) power supply voltage for a depression operation, and a ground power source for applying a ground voltage for not performing an update (non-implementation of update). The positive (+) power supply voltage may be VDD, and the negative (-) power supply voltage may be -VDD. The absolute values of VDD and -VDD may be the same, but may also be different. The ground voltage may be expressed as GND. Additionally, a signal for a potentiation operation, a signal for a depression operation, and a signal for not performing an update may be input to the input portion of the update multiplexer MP11. According to the signal input to the input portion of the update multiplexer MP11, the update multiplexer MP11 may apply any one of the positive (+) power supply voltage (i.e., VDD), the negative (-) power supply voltage (i.e., - VDD), and the ground voltage (i.e., GND) through the corresponding bit line BL to the update cell UC11.

According to one embodiment, the neuromorphic circuit may further include a comparison circuit unit CC11 connected to each of the plurality of bit lines BL. The comparison circuit unit CC11 may be a circuit which may distinguish and output a first signal, a second signal, and a third signal based on a positive (+) threshold voltage and a negative (-) threshold voltage. The comparison circuit unit CC11 may be used to read information stored in the update cell UC11. The comparison circuit unit CC11 may be the same or similar to the comparison circuit unit CC10 described with reference to FIG. 1 and FIG. 12. Additionally, the neuromorphic circuit may further include a second switch SH2 connected between each of the plurality of bit lines BL and the corresponding comparison circuit unit CC11. The second switch SH2 may be a switching device (circuit). The second switch SH2 may be called a 'read switch'.

According to one example, the first switch SH1 may be disposed between the second switch SH2 and the plurality of word lines WL. The first switch SH1 may be disposed between the plurality of word lines WL and the update multiplexer MP11. The first switch SH1 and the second switch SH2 may be disposed between the update multiplexer MP11 and the comparison circuit unit CC11. Additionally, an end of the bit line BL may be grounded. The comparison circuit unit CC11 may be connected to the bit line BL between the grounded end of the bit line BL and the second switch SH2.

According to this embodiment, both an update operation and a read operation may be performed by using the update multiplexer MP11 and the comparison circuit unit CC11 connected to one bit line BL. Accordingly, the configuration of the update cell UC11 may be simplified and the number of wirings may be reduced.

Although not shown, the neuromorphic circuit may further include an inference cell array, and the configuration of the inference cell array may be the same or similar to that described in FIG. 13.

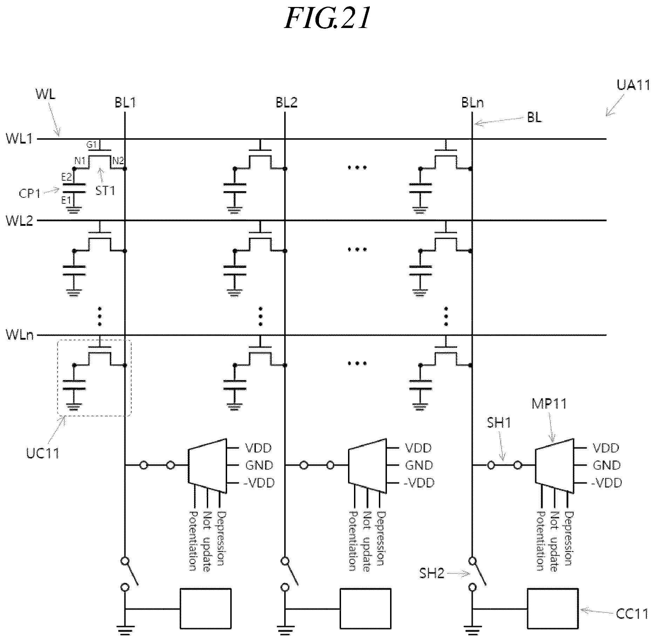

FIG. 21 is a circuit diagram for explaining a method of operating a neuromorphic circuit according to another embodiment of the present invention. This embodiment shows an update method for the update cell array UA11 as described in FIG. 20.

Referring to FIG. 21, the first switch SH1 may be closed and the second switch SH2 may be open. An input signal may be applied to a word line WL selected from the plurality of word lines WL, and any one of the positive (+) power supply voltage (i.e., VDD) and negative (-) power supply voltage (i.e., -VDD), and a ground voltage (i.e., GND) may be applied to the update cell UC11 through the bit line BL by using the update multiplexer MP11. At this time, an ON pulse generated with a probability proportional to the x value may be applied to the selected word line WL, and the update switch (i.e., SH1) of the corresponding bit line BL may be turned on by a pulse generated with a probability proportional to the d value. The update multiplexer MP11 may apply a positive (+) power supply voltage (i.e., VDD) for a potentiation operation, may apply a negative (-) power supply voltage (i.e., - VDD) for a depression operation, and may apply a ground voltage (i.e., GND) for not perform an update.

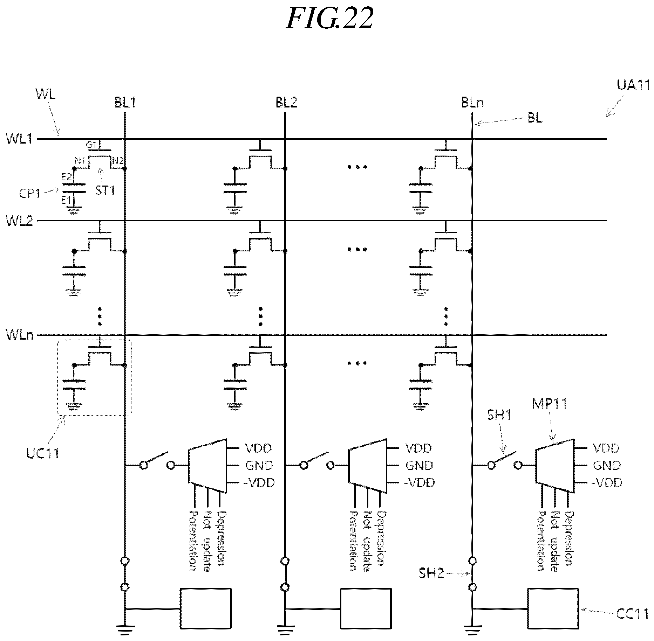

FIG. 22 is a circuit diagram for explaining a method of operating a neuromorphic circuit according to another embodiment of the present invention. This embodiment shows a method of reading the update cell array UA11 as described in FIG. 20.

Referring to FIG. 22, the second switch SH2 may be closed and the first switch SH1 may be open. Additionally, a read operation for the update cell array UA11 may be performed in the same or similar manner as described in FIG. 14. At this time, the comparison circuit unit CC11 may distinguish and output the first signal, the second signal, and the third signal based on the positive (+) threshold voltage and the negative (-) threshold voltage.

Additionally, although not shown, an update operation for the inference cell array may be performed. The update operation for the inference cell array may be the same or similar to that described in FIG. 15.

According to the embodiments of the present invention described above, it is possible to implement an update cell which is energy efficient, has less noise effect, and may reduce area overhead, and a neuromorphic circuit including the same. According to embodiments of the present invention, it is possible to implement a neuromorphic circuit which may perform a weight update by using a capacitor-based device with low write noise, and may also obtain area and energy advantages by using a small-sized comparison circuit rather than a conventional ADC. Furthermore, according to embodiments of the present invention, it is possible to implement a method of operating a neuromorphic circuit which may remarkably reduce power consumption, have less noise influence, and reduce area overhead, and a learning method applying the same. The method of operating a neuromorphic circuit according to embodiments may be usefully applied to on-chip learning. According to embodiments of the present invention, it is possible to implement a neuromorphic device (neuromorphic system) having excellent performance and remarkable advantages in terms of area and energy.

In this specification, the preferred embodiments of the present invention have been disclosed, and although specific terms have been used, they are only used in a general sense to easily explain the technological content of the present invention and to help understanding the present invention, and they are not used to limit the scope of the present invention. It is obvious to those having ordinary skill in the related art to which the present invention belong that other modifications based on the technological idea of the present invention may be implemented Furthermore to the embodiments disclosed herein. It will be understood to those having ordinary skill in the related art that in connection with an update cell, a neuromorphic circuit including the same, and a method of operating a neuromorphic circuit according to the embodiments described with reference to FIG. 1 to FIG. 22, various substitutions, changes, and modifications may be made without departing from the technological spirit of the present invention. Therefore, the scope of the invention should not be determined by the described embodiments, but should be determined by the technological concepts described in the claims.

The embodiments of the present invention may be applied to electronic circuits/devices, methods of operating the same, and apparatuses including electronic circuits/devices. The embodiments of the present invention may be applied to an update cell, a neuromorphic circuit including the same, and a method of operating a neuromorphic circuit.

## Claims

1. A neuromorphic circuit comprising:
an update cell array, and
wherein the update cell array includes a plurality of word lines; a plurality of bit lines intersecting the plurality of word lines; and a plurality of update cells respectively disposed at intersections of the plurality of word lines and the plurality of bit lines, and
wherein the update cell includes:
a capacitor including a first electrode and a second electrode;
a switching transistor including a first node connected to the second electrode, a second node connected to the bit line, and a gate connected to the word line; and
a charging/discharging circuit unit connected to the capacitor for charging and discharging the capacitor.

2. The neuromorphic circuit of claim 1, further comprising a comparison circuit unit connected to each of the plurality of bit lines, and wherein the comparison circuit unit is configured to distinguish and output a first signal, a second signal, and a third signal based on a positive (+) threshold voltage and a negative (-) threshold voltage.

3. The neuromorphic circuit of claim 1, wherein, for the charging/discharging circuit unit, a first power source for applying a positive (+) power supply voltage, a second power source for applying a negative (-) power supply voltage, and a connection node connected to the second electrode are defined.

4. The neuromorphic circuit of claim 3, wherein the charging/discharging circuit unit includes:
a first programming transistor and a first selection transistor connected in series between the first power source and the connection node, and
a second programming transistor and a second selection transistor connected in series between the second power source and the connection node.

5. The neuromorphic circuit of claim 3, wherein the charging/discharging circuit unit includes:
a first programming transistor connected between the first power source and the connection node;
a second programming transistor connected between the second power source and the connection node;
a first AND gate circuit or a first NAND gate circuit connected to a gate of the first programming transistor; and
a second AND gate circuit or a second NAND gate circuit connected to a gate of the second programming transistor.

6. The neuromorphic circuit of claim 3, wherein the charging/discharging circuit unit includes:
a first programming transistor connected between the first power source and the connection node; and
a second programming transistor connected between the second power source and the connection node,
wherein each of the first and second programming transistors has a dual gate structure or a double gate structure.

7. The neuromorphic circuit of claim 3, wherein the positive (+) power supply voltage and the negative (-) power supply voltage are supplied by one power supply unit, the power supply unit includes functions of the first and second power sources, and
the charging/discharging circuit unit includes a programming transistor and a selection transistor connected in series between the power supply unit and the connection node.

8. The neuromorphic circuit of claim 3, wherein the positive (+) power supply voltage and the negative (-) power supply voltage are supplied by one power supply unit, the power supply unit includes functions of the first and second power sources, and
the charging and discharging circuit unit includes a programming transistor connected between the power supply unit and the connection node, and an AND gate circuit or a NAND gate circuit connected to a gate of the programming transistor.

9. The neuromorphic circuit of claim 1, wherein the neuromorphic circuit further includes an inference cell array, and
wherein the inference cell array includes a plurality of first wirings; a plurality of second wirings intersecting the plurality of first wirings; and a plurality of inference cells respectively disposed at intersections of the plurality of first wirings and the plurality of second wirings.

10. A neuromorphic circuit comprising:
an update cell array including a plurality of word lines, a plurality of bit lines intersecting the plurality of word lines, and a plurality of update cells respectively disposed at intersections of the plurality of word lines and the plurality of bit lines, and wherein the update cell includes a capacitor including a first electrode and a second electrode, and a switching transistor including a first node connected to the second electrode, a second node connected to the bit line, and a gate connected to the word line;
an update multiplexer connected to each of the plurality of bit lines; and
a first switch connected between each of the plurality of bit lines and the update multiplexer corresponding thereto.

11. The neuromorphic circuit of claim 10, further comprising:
a comparison circuit unit which is connected to each of the plurality of bit lines and distinguishes and outputs a first signal, a second signal, and a third signal based on a positive (+) threshold voltage and a negative (-) threshold voltage; and
a second switch connected between each of the plurality of bit lines and the comparison circuit unit corresponding thereto.

12. The neuromorphic circuit of claim 10, wherein the update multiplexer is connected to a first power supply for applying a positive (+) power supply voltage for a potentiation operation; a second power supply for applying a negative (-) power supply voltage for a depression operation; and a ground power source for applying a ground voltage for non-implementation of update.

13. A method of operating a neuromorphic circuit wherein the neuromorphic circuit comprises:
an update cell array including an update cell consisting of a plurality of word lines, a plurality of bit lines intersecting the plurality of word lines, and a plurality of update cells respectively disposed at intersections of the plurality of word lines and the plurality of bit lines; and
a comparison circuit unit connected to each of the plurality of bit lines and capable of distinguishing and outputting a first signal, a second signal, and a third signal based on a positive (+) threshold voltage and a negative (-) threshold voltage, and
the method comprises performing a read operation for the update cell array, and
wherein the performing a read operation includes a step for distinguishing and outputting the first signal, the second signal, and the third signal by applying an input signal to a word line selected from among the plurality of word lines, and using the comparison circuit unit for a first group of update cells connected to the selected word line.

14. The method of operating a neuromorphic circuit of claim 13, wherein the neuromorphic circuit further comprises an inference cell array including a plurality of first wirings, a plurality of second wirings which intersect the plurality of first wirings, and a plurality of inference cells respectively disposed at intersections of the plurality of first wirings and the plurality of second wirings, and
the method further comprises performing an update operation for the inference cell array, and
wherein the performing an update operation includes applying an input signal to a first wiring selected from the plurality of first wirings, and performing an update operation for a first group of inference cells connected to the selected first wiring, wherein the update operation for the first group of inference cells is performed according to the first signal, the second signal, and the third signal at a position corresponding to each of the update cells of the first group.

15. The method of operating a neuromorphic circuit of claim 14, wherein an 1 step potentiation operation is performed for the inference cell corresponding to the first signal,
an 1 step depression operation is performed for the inference cell corresponding to the second signal, and
an update operation is not performed for the inference cell corresponding to the third signal.

16. The method of operating a neuromorphic circuit of claim 14, wherein the performing a read operation for the update cell array is repeatedly performed while selecting the word lines one by one, and
the performing an update operation for the inference cell array is repeatedly performed while selecting the first wirings one by one.
